# EUROPEAN PATENT APPLICATION

(11) **EP 2 015 357 A1**
(43) Date of publication of application: **14.01.2009**
(21) Application number: 07425423.6
(22) Date of filing: 09.07.2007
(51) Int. Cl.: H01L 21/8229, H01L 27/102, H01L 27/24, H01L 45/00

(54) **Process for manufacturing an array of cells including selection bipolar junction transistors with projecting conduction regions**

(71) Applicant: STMicroelectronics S.r.l., 20041 Agrate Brianza (MI) (IT)
(72) Inventor: Pellizzer, Fabio, 20040 Cornate d'Adda (IT); Benvenuti, Augusto, 24040 Lallio (IT); Cappelletti, Paolo, 20030 Seveso (IT); Bez, Roberto, 20146 Milano (IT); Pirovano, Agostino, 20011 Corbetta (IT)
(74) Representative: Cerbaro, Elena

(57) **Abstract**

A process for manufacturing an array of cells in a body (1) of semiconductor material wherein a common conduction region (11) of a first conductivity type and a plurality of shared control regions (12), of a second conductivity type, are formed in the body. The shared control regions (12) extend on the common conduction region (11) and are laterally delimited by insulating regions (32). Then, a grid-like layer (36) is formed on the body (1) to delimit a first plurality of empty regions (38) directly overlying the body and conductive regions of semiconductor material and the first conductivity type (44) are formed by filling the first plurality of empty regions (38), each conductive region forming, together with the common conduction region and an own shared control region (12), a bipolar junction transistor (20).

## Description

The present invention relates to a process for manufacturing an array of cells including selection bipolar junction transistors having projecting regions and to the obtained array. In particular, the invention refers to a memory array of a phase change memory (PCM) device, without being limited thereto.

As is known, phase change memories are formed by memory cells connected at the intersections of bitlines and wordlines and comprising each a memory element and a selection element.

Memory elements comprise a phase change region made of a phase change material, i.e., a material that may be electrically switched between a generally amorphous and a generally crystalline state across the entire spectrum between completely amorphous and completely crystalline states. Typical materials suitable for such an application include various chalcogenide elements. The state of the phase change materials is non-volatile, absent application of excess temperatures, such as those in excess of 150°C for extended times. When the memory is set in either a crystalline, semicrystalline, amorphous, or semi-amorphous state representing a resistance value, that value is retained until reprogrammed, even if power is removed. This is because the programmed value represents a phase or physical state of the material (e.g., crystalline or amorphous).

Selection elements may be formed according to different technologies, for example they can be implemented by diodes, by MOS transistors or bipolar transistors.

Solutions comprising bipolar transistors as selection elements are described for example in EP-A-1 408 549.

In the known solution, the collector region of the selection element is formed by a buried, shared region of the substrate, overlaid by a shared base region formed in an active area. The various active areas are delimited by shallow trench insulations of dielectric material. An emitter region and a base contact region are also formed in the active area, surrounded by the shared base regions, by implanting them through own masks. Each emitter region is then connected to an own memory element, in turn connected to a bitline; the base contact is connected to a wordline through plugs extending in an insulating layer overlying the substrate. The memory cells that are adjacent in the direction of the rows of the memory array are connected to a same wordline; the memory cells that are adjacent in the direction of the columns of the memory array are connected to a same bitline.

With the above process, the present desire to scale the dimensions of the transistor array may essentially cause two problems. One problem may derive from the increasing proximity of the emitter and base contacts, which may cause an increase in the current leakage, thus possibly impairing or negatively affecting the correct operation of the memory device. Another problem may reside in increasing proximity of also the active areas, which may worsen the aspect ratio of the shallow trench regions, whose depth cannot be reduced to avoid a short of the bases accommodated in adjacent active areas to be electrically connected.

The object of the invention is thus to provide a process for forming an array of selection transistors that improves the confinement of the active regions of the transistors.

According to the present invention, there are provided a process for manufacturing an array of cells and the obtained array, as defined respectively in claims 1 and 13.

For the understanding of the present invention, preferred embodiments thereof are now described, purely as non-limitative examples, with reference to the enclosed drawings, wherein:
- Figure 1 shows the layout of a first embodiment of an array of selection transistors;
- Figures 2 and 3 show cross-sections, taken along line II-II and respectively line III-III of Fig. 1;
- Figure 4 shows a cross-section, analogous to Fig. 2, in a subsequent manufacturing step;
- Figure 5 shows the layout of masks used for the present array, in a subsequent manufacturing step;
- Figure 6 shows the layout of the present array, in a subsequent manufacturing step;
- Figure 7 shows a cross-section, taken along line VII-VII of Fig. 6;
- Figure 8 shows the layout of the present array, in a subsequent manufacturing step;
- Figure 9 shows a cross-section, taken along line IX-IX of Fig. 8;
- Figure 10 shows a cross-section taken along line X-X of Fig. 8, in a subsequent manufacturing step;
- Figure 11 shows a cross-section, analogous to the cross-section of Figure 9, in a subsequent manufacturing step;
- Figure 12 shows the layout of the present array, in a subsequent manufacturing step;
- Figures 13 and 14 show cross-sections, taken along line XIII-XIII and respectively line XIV-XIV of Fig. 12;
- Figure 15 shows the layout of the present array, in a subsequent manufacturing step;
- Figures 16 and 17 show cross-sections, taken along line XVI-XVI and respectively line XVII-XVII of Fig. 15;
- Figure 18 shows the layout of the present array, in a subsequent manufacturing step;
- Figures 19 and 20 show cross-sections, taken along line XIX-XIX and respectively line XX-XX of Fig. 20;
- Figure 21 shows the layout of a second embodiment of the present array;
- Figure 22 shows a cross-section, taken along line XXII-XXII of Fig. 21;
- Figures 23 and 24 show cross-sections, analogous to Figures 13 and 14 according to a third embodiment of the present array;
- Figures 25 and 26 show cross-sections of the third embodiment of the present array, in a subsequent manufacturing step;
- Figures 27 and 28 show cross-sections of the third embodiment of the present array, in a subsequent manufacturing step;
- Figure 29 shows a cross-section, taken along line XIX-XIX of Fig. 18, according to a fourth embodiment;
- Figure 30 is a system depiction for another embodiment of the invention.

According to a first embodiment, an array of memory cells is formed in a body 1 of monocrystalline semiconductor material having a surface 3 and including a heavily doped substrate 6 of P-type; a subcollector region 7, of P-type and high doping level, is formed in the substrate 6; a common collector region 11, also of P-type and lower doping level than the subcollector region 7, is formed on the subcollector region 7.

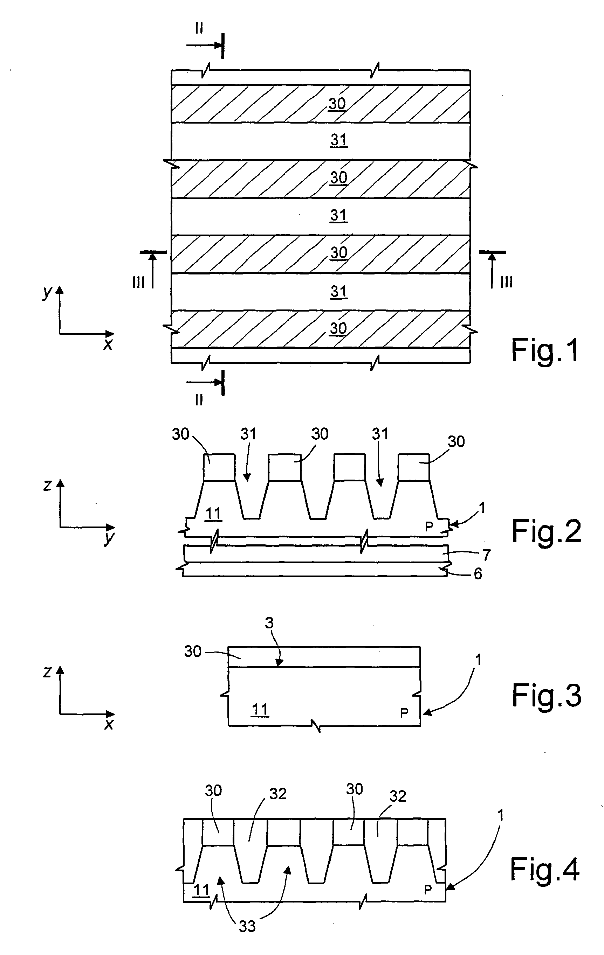

Thereafter, active regions are defined in the substrate. To this end, as shown in Figures 1-3, a pad oxide layer (not shown) and a nitride layer are deposited in sequence on the surface 3 of the body 1 and, using a suitable mask, are defined to obtain a plurality of parallel nitride strips 30 extending along direction X in Fig. 1. Then, the body 1 is etched to form a plurality of trenches 31 between the nitride strips 30, as visible from the cross-section of Fig. 2.

After removing the nitride mask (not shown), the walls of the trenches 31 are oxided and an oxide layer is deposited to fill the trenches 31. Then, the body 1 is planarized, e.g. through CMP (Chemical Mechanical Polishing), obtaining the cross-section of Figure 4. Thus, the obtained structure has a plurality of field oxide regions 32 that fill the trenches 31 and the silicon regions of the body 1 delimited by the field oxide regions 32 form active areas 33.

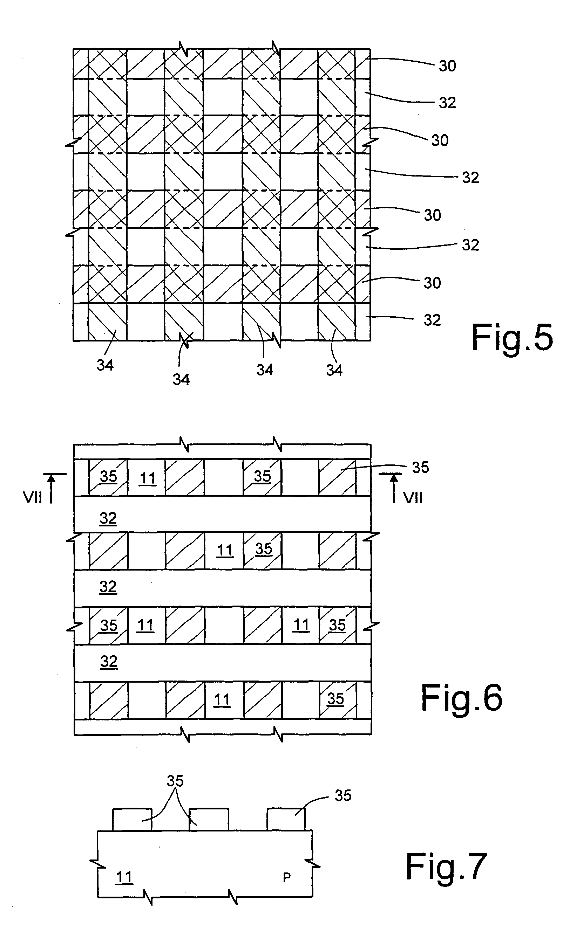

Subsequently, a mask 34 is deposited, including strip-like portions extending transversely to the nitride strips 30 (Figure 5). Then, the nitride strips 30 are dry etched, where exposed, to obtain sacrificial regions 35 which are visible from the layout of figure 6 and the cross-section of Figure 7. Here, the cross-section taken perpendicularly to figure 7 is not shown, being the same as the cross-section of Figure 4.

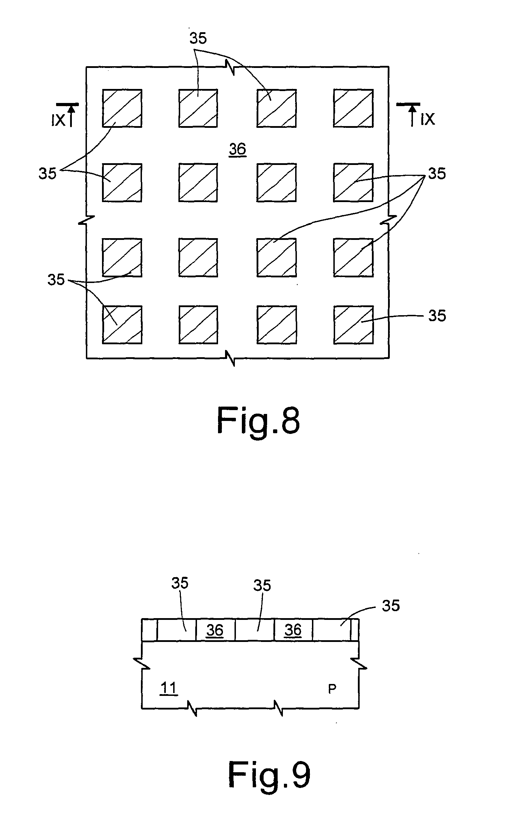

After removing the nitride mask (34), an oxide layer is deposited to fill the space between the sacrificial regions 35; then the oxide layer is planarized, e.g. through CMP, to obtain a grid-like layer 36 surrounding the sacrificial regions 35, as shown in Figures 8 and 9.

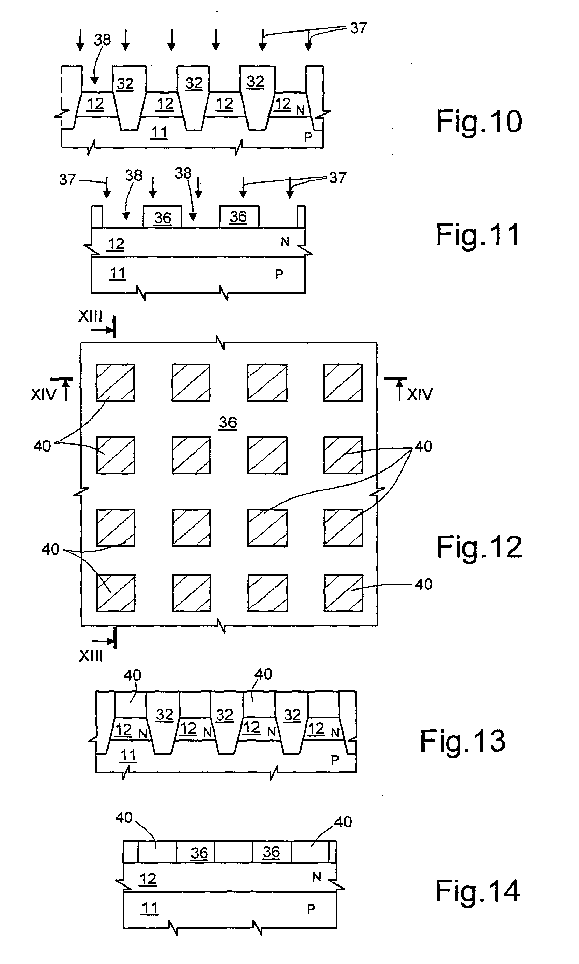

Then, the sacrificial regions 35 and the underlying pad oxide regions (not shown) are completely removed, e.g. through two wet etches, thereby forming a plurality of empty regions 38 surrounded by grid-like layer 36 (Figures 10 and 11). Then base regions 12 are implanted with an N-type dopant, as schematically shown in Figures 10 and 11 by arrows 37. In particular, the implant conditions are studied so that the base regions 12 extend along the entire active areas 33, thus partly under the grid-like layer 36 (as particularly evident from Figure 11), forming shared bases for all the transistors to be formed in a same active area. Performing the base implant at this stage ensures a proper diffusion of the base dopant and a uniform profile thereof.

Thereafter, Figures 12-14, a polysilicon layer is deposited. The polysilicon layer fills the empty regions 38 and is then planarized, e.g. by CMP, to obtain a plurality of projecting regions 40, dice-shaped as the removed sacrificial regions 35 and extending above the surface (3) of the body. The projecting regions 40 can be intrinsic or slightly P-type doped.

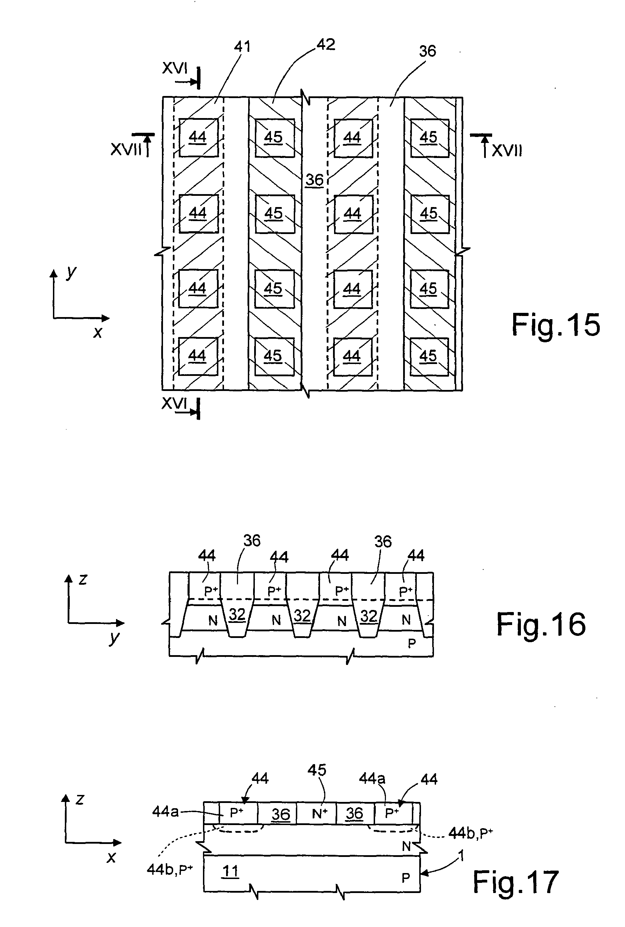

Thereafter, emitter and base contact implants are made in any sequence, using own masks, as shown in Figure 15, wherein the emitter mask is indicated by 41 and the base contact mask is indicated by 42. Therefore, the projecting regions 40 aligned along direction X are alternately doped with P⁺ dopants (and form emitter regions 44) and with N⁺ dopants (and form base contact regions 45). Furthermore, all the projecting regions 40 mutually aligned along direction Y are either doped with P⁺ dopants or N⁺ dopants. The P⁺-type dopants also diffuse in part into the body 1, to form a P⁺/N junction therein, thus in a monocrystalline portion of the device (diffused portions 44b). Therefore, the emitter regions 44 comprise both a polycrystalline portion 44a (in the projecting region) and a monocrystalline portion 44b(inside the body 1) and the presence of the polycrystalline portion 44a does not impair the functioning of the finished transistors since the junction with the shared base region 12 is formed by the monocrystalline portion 44b.

On the contrary, the implant of the base contact regions 45 may be performed so as to avoid the diffusion of the dopant within the body 1, so that N⁺-dopant diffuse practically only through the depth of the projecting regions 40 to form the base contact regions 45 and do not extend or extend only in a minimum part in the body 1. Thereby it is assured that both the base emitter regions 44 and contact regions 45 are essentially confined within the grid-like layer 36 and cannot contact each other. Thus, the structure of Figures 16 and 17 is obtained.

Thereafter, silicide regions 46 are formed on the emitter and base contact regions 44, 45 in a per se known manner.

Then, the body 1 is covered by a first layer of insulating material, forming the bottom portion of a dielectric region 21; vias are formed in the first layer of insulating material; the vias are filled with a barrier layer, e.g. Ti/TiN, and with tungsten, forming first plugs 22 and lower portion of second plugs 23.

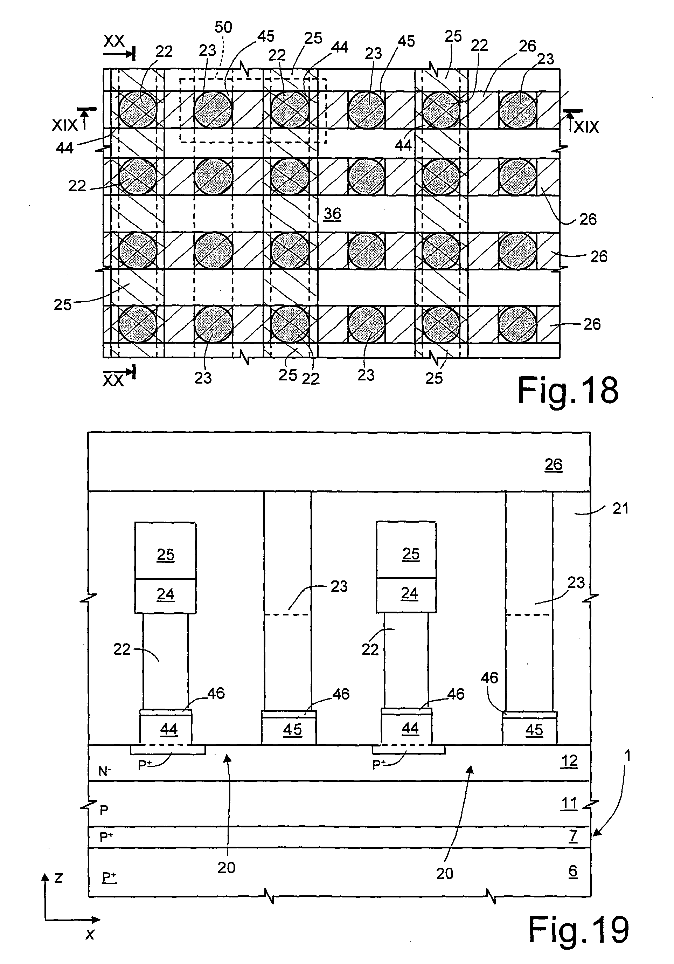

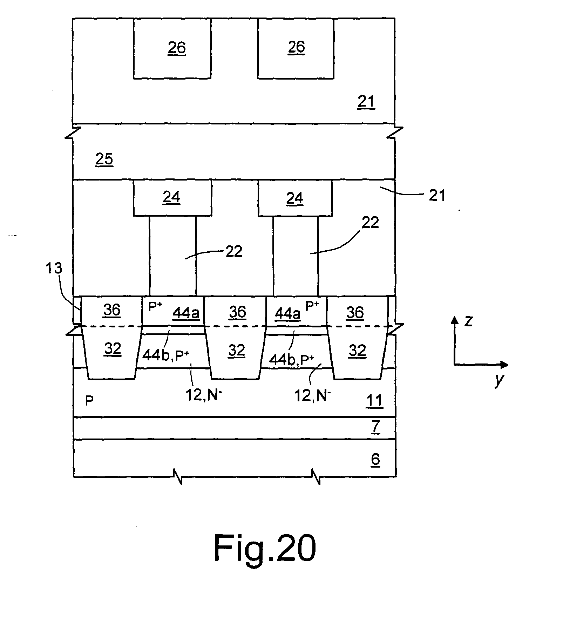

The process continues with the necessary steps to form the memory elements, including forming the chalcogenic storage elements 24, first metal lines 25, an upper portion of the dielectric region 21, an upper portion of the plugs 23, and second metal lines 26, e.g. as described in European patent application N. 01128461.9, to obtain the structure shown in Figures 18-20.

Thereby, each emitter region 44 and the adjacent base contact region 45 form, together with the subcollector region 7, the common collector region 11 and the respective shared base region 12, a junction bipolar transistor 20, connected to a wordline 26 and a bitline 25, through an own storage element 24.

With the just described embodiment, each cell 50 (shown in Figure 18 by dashed lines) has a dimension of about 8F², where F is the minimum geometry that defines a memory cell.

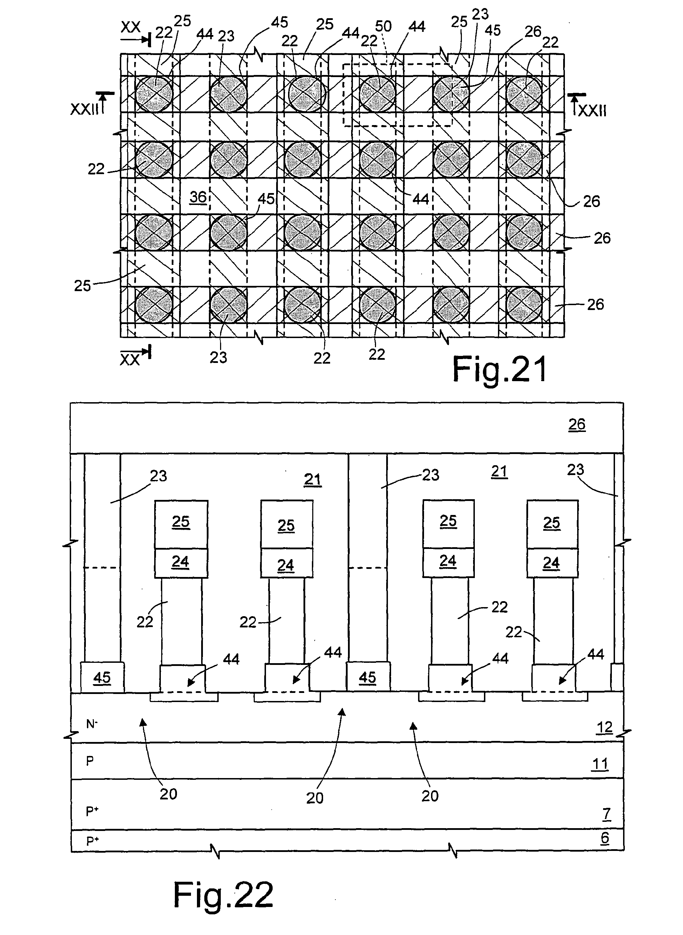

Figures 21 and 22 show the layout and the cross-section of an embodiment wherein each base contact region 45 and the respective second contact 23 is shared by two adjacent bipolar transistors 20. Therefore, in the cross-section of Figure 22, two emitter regions 44 extend adjacent to each other between two subsequent base contact regions 45. With this embodiment, the cell dimension (shown in Figure 18 by dashed lines) is about 6F².

Further embodiments (not shown) may include a single base contact region 45 for a plurality of emitter regions 44, thus further reducing the dimensions of the single memory cell down to a theoretical minimum of 4F².

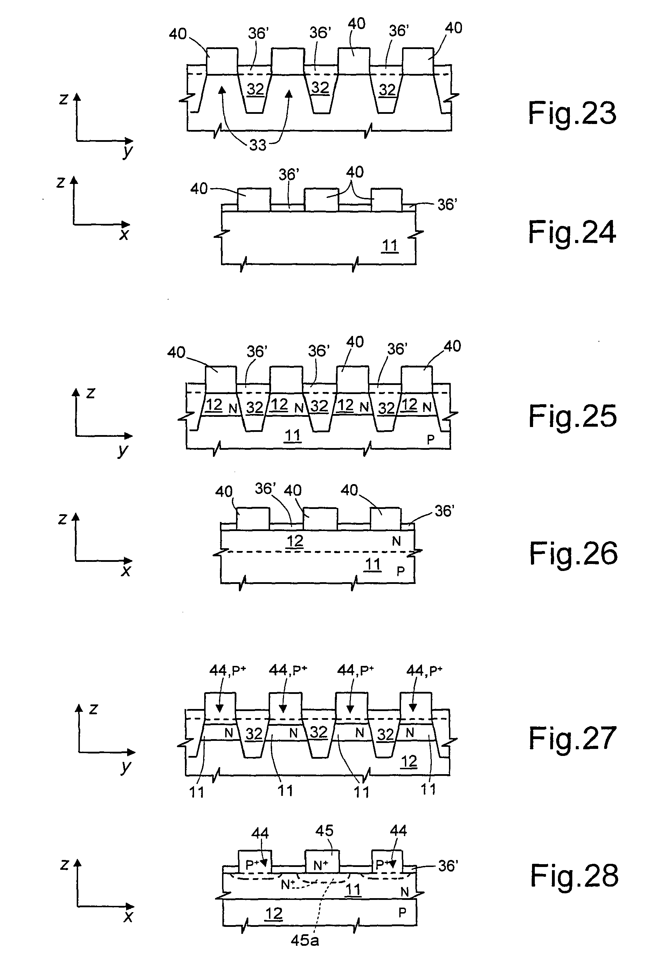

Figures 23-28 show a different embodiment of the present process, suitable for manufacturing the transistor array together with a circuitry (not shown). In detail, after removing the sacrificial regions 35 and the underlying pad oxide (after Figures 6 and 7) and before depositing the polysilicon layer (before Figures 8 and 9) a thin oxide layer is formed, e.g. grown, to form the gate oxide in the circuitry; then the thin oxide layer is removed in the array area. Then, the polysilicon layer is deposited and planarized as discussed with reference to Figures 8, 9, while preserving the future gate regions of the MOS transistors in the circuitry. Thereafter, a wet oxide etch is performed to remove part of the grid like layer 36, as shown in Figures 23 and 24. Thus, a shallower grid like layer 36' is obtained. Then the polysilicon layer is masked and etched in the circuitry to form the gate regions of the MOS transistors (not shown).

Subsequently, the shared base implant is performed, as shown in Figures 25 and 26, to obtain the shared base regions 12. Then, Figures 27, 28, the emitter and the base contact regions 44, 45 are implanted, as described with reference to Figures 15-17. Here the same implants may be used to form source and drain regions of MOS transistors in the circuitry (not shown), in which case the base contact implant may diffuse into the body 1, as shown by portion 45a. The process then proceeds as discussed above with reference to Figures 18-20.

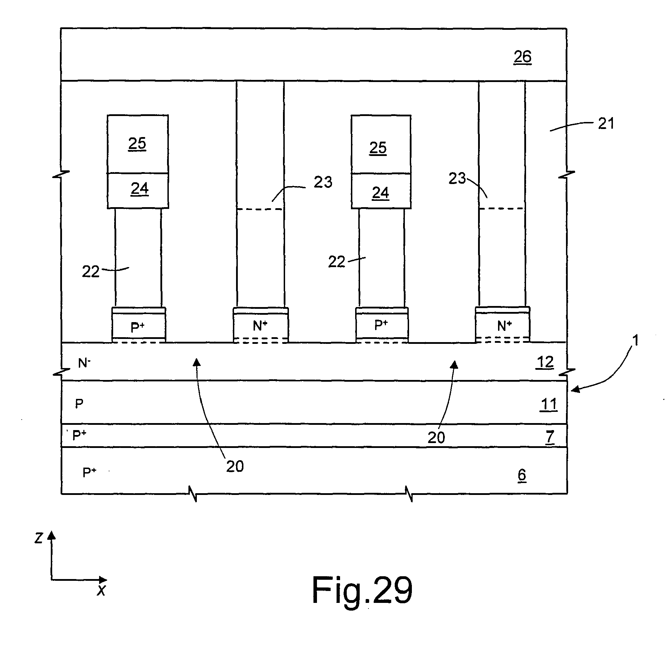

According to the embodiment of Figure 29, the projecting regions 40 are formed, after the removal of the sacrificial regions 35 of nitride and of underlying pad oxide in Figures 6-7, by an epitaxial growth instead of by deposition. In this case, the projecting regions 40 are completely formed of a monocrystalline material; thereby the emitter/base junctions can be formed on the interface between the projecting regions 40 and the body 1 or slightly above such interface as shown in the figure. In practice, the emitter implant is studied so as to substantially avoid the diffusion of P dopants into the body 1 and the emitter regions 44 extend through only a portion of the respective projecting regions 40.

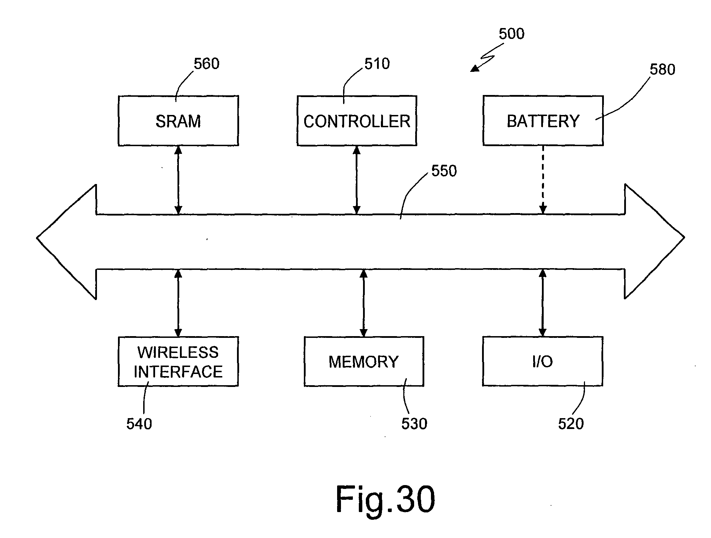

Turning to Figure 30, a portion of a system 500 in accordance with an embodiment of the present invention is described. System 500 may be used in wireless devices such as, for example, a personal digital assistant (PDA), a laptop or portable computer with wireless capability, a web tablet, a wireless telephone, a pager, an instant messaging device, a digital music player, a digital camera, or other devices that may be adapted to transmit and/or receive information wirelessly. System 500 may be used in any of the following systems: a wireless local area network (WLAN) system, a wireless personal area network (WPAN) system, a cellular network, although the scope of the present invention is not limited in this respect.

System 500 includes a controller 510, an input/output (I/O) device 520 (e.g. a keypad, display), static random access memory (SRAM) 560, a memory 530, and a wireless interface 540 coupled to each other via a bus 550. A battery 580 is used in some embodiments. It should be noted that the scope of the present invention is not limited to embodiments having any or all of these components.

Controller 510 comprises, for example, one or more microprocessors, digital signal processors, microcontrollers, or the like. Memory 530 may be used to store messages transmitted to or by system 500. Memory 530 may also optionally be used to store instructions that are executed by controller 510 during the operation of system 500, and may be used to store user data. Memory 530 may be provided by one or more different types of memory. For example, memory 530 may comprise any type of random access memory, a volatile memory, a non-volatile memory such as a flash memory and/or a phase change memory including the memory array 1 discussed herein.

I/O device 520 may be used by a user to generate a message. System 500 uses wireless interface 540 to transmit and receive messages to and from a wireless communication network with a radio frequency (RF) signal. Examples of wireless interface 540 may include an antenna or a wireless transceiver, although the scope of the present invention is not limited in this respect.

The advantages of the described embodiments are the following. The arrangement of the emitter regions above the surface 3 of the monocrystalline body 1 (with, in case, only a portion thereof in the monocrystalline body 1) allows to reduce the depth of the shared base region and thus of the field oxide regions 32; thereby, even in case of scaling of the dimensions of the array, the aspect ratio of the trenches 31 and thus of the field oxide regions 32 is not worsened.

Furthermore, since the emitter and base contact regions 44, 45 are formed mainly in the projecting regions 40 extending above the monocrystalline body 1, any portions thereof formed in the monocrystalline body 1 (due to the vertical diffusion of dopants) is quite shallow, and the lateral diffusion thereof is very limited. Thereby, the risk of direct electrical contact between the emitter and the base contact regions 44, 45 is very low and can be practically prevented if the base contact is confined in the projecting regions 40. For example, the implant of the base contact regions 45 may be carried out to reach only the upper portion of the projecting regions 40 and the lower (shallower) portion of the projecting regions 40 is practically not reached (or far less reached than the upper portion), thereby being less doped than the upper portion.

The risk of short-circuit between the emitter and the base contact regions 44, 45 can be further reduced if the projecting regions 40 are formed by an epitaxial growth instead by deposition, as described with reference to Figure 29. In fact, the confinement of the P dopants in the projecting regions 40 allows the shared base region 12 and the field oxide regions 32 to be made even shallower, further reducing any aspect ratio problems in case of high scaling.

The formation of the emitter base junction 44 within the projecting regions 40 allows the doping level of the shared base 12 to be increased, without causing an increase of the leakage at the emitter/base junction. Thus, the base resistance is reduced, and it is possible to reduce the number of base contact regions 45 shared by different transistors 20. Therefore, it is possible to have just one base contact region 45 every four, six or even eight emitter regions 45, without impairing the operation of the transistors.

The emitter and base contact regions 44, 45 are self-contained in the projecting regions 40, being delimited, in a top view, by the grid like layer 35. Thus, they are self-aligned to each other and are substantially independent of any mask misalignments.

Finally, it is clear that numerous variations and modifications may be made to the array and process described and illustrated herein, all falling within the scope of the invention as defined in the attached claims.

For example, the same selection array may be used for selection of other storage elements, different from the chalcogenic storage elements 24, or of other two- or three-terminal elements that are compatible with standard CMOS back-end processes.

Furthermore, the semiconductor material deposited or grown to form the projecting regions 40 may be doped in situ, e.g. of P⁺-type, using borane. In this case, the emitter doping mask 41 can be spared, reducing the costs for the manufacture, even if the base contact implant would require higher doses.

Moreover, a wet etch of the oxide may be performed after the definition of the nitride strips 30 and the filling of the trenches 31 (after the planarization of Figure 4). The wet etch may be performed so as to substantially remove only the oxide protruding above the surface 3 of the body 1. Such an etching is advantageous during the subsequent etching of the nitride strips 30 using the mask of Figure 5; the presence of any oxide laterally to the nitride strips 30 may in fact cause the formation of nitride stringers adjacent to the oxide. Such stringers could act like spacers and prevent a correct definition of the sacrificial regions 35 and thus of the projecting regions 40.

In the embodiment of Figures 23-28, the shared base region can be implanted also before forming the projecting regions 40, analogously to the embodiment described with reference to Figures 1-20; vice versa, in the embodiments described with reference to Figures 1-20 and 29, the shared base region can be implanted after forming the projecting regions 40, analogously to the embodiment described with reference to Figures 23-28.

The same process may be used to form NPN junction transistors, instead of PNP transistors 20.

## Claims

1. A process for manufacturing an array of cells, **characterized by** the steps of:
providing a body (1) of semiconductor material including a common conduction region (11) of a first conductivity type;
forming a plurality of shared control regions (12), of a second conductivity type, extending on said common conduction region (11) and laterally delimited by insulating regions (32);
forming, on said body (1), a grid-like layer (36) delimiting a first plurality of empty regions (38) directly overlying said body;
forming conductive regions of semiconductor material of the first conductivity type (44) by filling said first plurality of empty regions (38), each conductive region forming, together with said common conduction region and an own shared control region (12), a bipolar junction transistor (20).

2. A process according to claim 1, wherein the step of forming a grid like layer (36) comprises forming a second plurality of empty regions (38) directly overlying said body (1); further comprising forming contact regions (45) of said second conductivity type by filling said second plurality of empty regions simultaneously with filling said first plurality of empty regions, said contact regions being in contact with said shared control regions (12) and having a higher doping level than said shared control regions (12).

3. A process according to claim 1 or 2, wherein the step of filling comprises depositing a polycrystalline layer and planarizing said polycrystalline layer.

4. A process according to claim 1 or 2, wherein the step of filling comprises epitaxially growing said projecting conductive regions (40) on said body (1) within said empty regions (38).

5. A process according to any of claims 1-4, wherein the step of filling comprises forming projecting regions (40) having a height and doping said plurality of projecting regions with conductivity determining agents diffusing throughout said height.

6. A process according to claim 5, wherein said conductivity determining agents diffuse in part in said body (1).

7. A process according to any of claims 1-4, wherein the step of filling comprises forming projecting regions (40) having a height and doping said plurality of projecting regions (40) with conductivity determining agents diffusing through a portion of said height.

8. A process according to any of claims 1-4, wherein the step of filling comprises forming projecting regions (40) with in situ doped semiconductor material.

9. A process according to any of claims 1-8, wherein the steps of forming a plurality of shared control regions (12) and forming a grid-like layer (36) comprises forming a sacrificial layer on said body (1), etching said sacrificial layer to form a plurality of sacrificial strips (30) extending parallel to each other, removing exposed portions of said body (1) to form a plurality of trenches between said sacrificial strips (30), filling said trenches with insulating material to form said insulating regions (32), etching said sacrificial strips to form sacrificial regions (35), depositing and planarizing an insulating layer to form the grid-like layer (36) and removing the sacrificial regions (35) to form the empty regions.

10. A process according to any of claims 1-9, wherein the step of forming a plurality of shared control regions (12) comprises implanting doping agents after forming the grid like layer (36) and before filling.

11. A process according to claim 5 or 6, wherein the step of forming a plurality of shared control regions (12) comprises implanting doping agents after forming projecting regions (40) and before doping said plurality of projecting regions (40).

12. A process according to any of claims 1-11, further comprising forming first plug regions (22) extending each on and in contact with a respective conductive region (44); forming storage regions (24) on and in contact with a respective first plug region (23); forming first access lines (25) on and in contact with a plurality of storage regions (24) aligned along a first direction; forming second plug regions (23) in contact with said shared control regions; and forming second access lines (26) on and in contact with a plurality of said second plug regions that are aligned along a second direction, perpendicular to said first direction.

13. An array (1) comprising a plurality of cells (50), each cell including a selection transistor (20) of a bipolar junction type, each said selection transistor (20) having a first (44), a second (11) and a control region (12, 45), said cell array comprising a body (1) of semiconductor material having a surface and including:
- a common region (11) of a first conductivity type, forming said second regions (11) of said selection transistors (20); and
- a plurality of shared control regions (12), of a second conductivity type, overlying said common region (11) and laterally delimited by insulating regions (13) formed below said surface,
**characterized in that** said first regions (44) are formed in projecting regions (40) extending above the surface of said body (1) and laterally delimited by a grid like layer (36) of insulating material extending above said surface, said first regions having the first conductivity type.

14. An array according to claim 13, wherein said projecting regions (40) are of monocrystalline material.

15. An array according to claim 13, wherein said projecting regions (40) are of polycrystalline material.

16. An array according to any of claims 13-15, wherein said projecting regions (40) have a height, said first regions (44) extend throughout the height of said projecting regions (40) and further comprise diffused portions (44b) of the first conductivity type extending within said body below and in contact with said projecting regions (40), said diffused portions (44a) being surrounded laterally and on the bottom by a respective shared control region (12).

17. An array according to any of claims 13-16, wherein each cell (50) also comprises a memory storage element (24) connected between a first region (14) of a respective selection transistor (20) and a respective first selection line (25) through a solid plug element of conductive material.

18. An array according to claim 17, wherein said memory storage element (24) is a chalcogenic storage element and the array is comprised in a phase change memory device.
